# EUROPÄISCHE PATENTANMELDUNG

(11) **EP 4 827 249 A2**
(43) Veröffentlichungstag der Anmeldung: **21.10.2026**
(21) Anmeldenummer: 26163086.7
(22) Anmeldetag: 09.03.2026
(51) Int. Cl.: H05K 1/02, H05K 1/184, H05K 1/11, H05K 3/30, H05K 3/341

(54) **VERFAHREN ZUM AUFBAU EINER ELEKTRISCHEN SCHALTUNG UND ELEKTRISCHE SCHALTUNG**

(30) Priorität: 17.04.2025 DE 102025115098
(71) Anmelder: Eberspächer Controls Landau GmbH & Co. KG, 76829 Landau (DE)
(72) Erfinder: Reichenbacher, Matthias, Graben-Neudorf (DE); Knopf, Christian, Hauenstein (DE)
(74) Vertreter: Ruttensperger Lachnit Trossin Gomoll

(57) **Zusammenfassung**

Eine elektrische Schaltung (10) umfasst eine Leiterplatte (22) und wenigstens ein Schaltungsbauteil (16) mit einer Mehrzahl von Kontaktanschlüssen (20, 34), wobei die Leiterplatte (12) in Zuordnung zu dem wenigstens einen Schaltungsbauteil (16) eine Aussparung (42) und Leiterbahnen (24, 40) wenigstens an einer ersten Seite (22) der Leiterplatte (12) aufweist, wobei das wenigstens eine Schaltungsbauteil (14) in die zugeordnete Aussparung (42) derart eingesetzt ist, dass wenigstens ein Teil der Kontaktanschlüsse (20, 34) des wenigstens einen Bauteils (16) an der ersten Seite (22) der Leiterplatte (12) im Bereich von an der ersten Seite (22) der Leiterplatte (12) vorgesehenen Leiterbahnen (24, 40) positioniert und damit elektrisch leitend verbunden ist, und wobei eine Kühlseite (26) des wenigstens einen Schaltungsbauteils (16) an einer von der ersten Seite (22) abgewandten zweiten Seite (46) der Leiterplatte (12) und im Wesentlichen in Richtung von der zweiten Seite (46) der Leiterplatte (12) weg orientiert positioniert ist.

## Beschreibung

Die vorliegende Erfindung betrifft ein Verfahren zum Aufbau einer elektrischen Schaltung sowie eine elektrische Schaltung, welche eine Leiterplatte und wenigstens ein Schaltungsbauteil aufweist, das mit wenigstens einem Teil seiner Kontaktanschlüsse mit an der selben Seite der Leiterplatte vorgesehenen Leiterbahnen elektrisch leitend verbunden ist.

Um bei derartigen elektrischen Schaltungen von Wärme generierenden Schaltungsbauteilen, wie zum Beispiel Leistungs-Halbleiterschaltern oder dergleichen, Wärme abführen zu können, weisen diese eine von der Leiterplatte abgewandt orientierte Kühlfläche auf, die beispielsweise nach der Integration einer derartigen elektrischen Schaltung in ein Gehäuse in Wärmeübertragungskontakt mit einer Innenoberfläche des Gehäuses steht, um auf diese Art und Weise Wärme über das Gehäuse nach außen abzuführen. Um diese Art der Wärmeabfuhr an beiden Seiten einer Leiterplatte nutzen zu können, ist es erforderlich, die auf diese Art und Weise zu kühlenden Schaltungsbauteile auf beide Seiten der Leiterplatte verteilt anzuordnen und dementsprechend mit an den beiden Seiten der Leiterplatte vorgesehenen Leiterbahnen im Allgemeinen durch Verlöten elektrisch leitend zu verbinden. Dies erfordert für die an den beiden Seiten der Leiterplatte angeordneten bzw. anzuordnenden Schaltungsbauteile separat durchzuführende Lötprozesse, was zu einer aufwendigen und dementsprechend auch kostenintensiven Produktion führt.

Es ist die Aufgabe der vorliegenden Erfindung, ein Verfahren zum Aufbau einer elektrischen Schaltung und eine elektrische Schaltung vorzusehen, welche bei einfacher Herstellungsprozedur einen eine effiziente Kühlung von Schaltungsbauteilen zulassenden Aufbau der elektrischen Schaltung vorsehen.

Gemäß einem ersten Aspekt der vorliegenden Erfindung wird diese Aufgabe gelöst durch ein Verfahren zum Aufbau einer elektrischen Schaltung, die elektrische Schaltung umfassend eine Leiterplatte und wenigstens ein Schaltungsbauteil mit einer Mehrzahl von Kontaktanschlüssen, wobei wenigstens ein Teil der Kontaktanschlüsse mit an der selben Seite der Leiterplatte vorgesehenen Leiterbahnen der Leiterplatte elektrisch leitend verbunden ist, und wobei das wenigstens eine Schaltungsbauteil eine an einer Seite der Leiterplatte positionierte und in Richtung von der Leiterplatte weg orientierte Kühlseite aufweist, wobei das Verfahren die Maßnahmen umfasst:
a) Bereitstellen wenigstens eines Schaltungsbauteils mit einer Mehrzahl von Kontaktanschlüssen und einer Kühlseite,
b) Bereitstellen einer Leiterplatte mit einer in Zuordnung zu dem wenigstens einen Schaltungsbauteil vorgesehenen Aussparung und Leiterbahnen wenigstens an einer ersten Seite der Leiterplatte,
c) Einsetzen des wenigstens einen Schaltungsbauteils in die Aussparung derart, dass wenigstens ein Teil der Kontaktanschlüsse des wenigstens einen Schaltungsbauteils an der ersten Seite der Leiterplatte im Bereich von an der ersten Seite der Leiterplatte vorgesehenen Leiterbahnen positioniert wird und die Kühlseite des wenigstens einen Schaltungsbauteils an einer von der ersten Seite abgewandten zweiten Seite der Leiterplatte und im Wesentlichen in Richtung von der zweiten Seite der Leiterplatte weg orientiert positioniert wird,
d) elektrisch leitendes Verbinden jedes im Bereich einer Leiterbahn an der ersten Seite der Leiterplatte positionierten Kontaktanschlusses mit der jeweils zugeordneten Leiterbahn.

Durch die erfindungsgemäße Vorgehensweise beim Aufbau einer elektrischen Schaltung werden die Funktion zum Herstellen einer elektrisch leitenden Verbindung des wenigstens einen Schaltungsbauteils einerseits und die Funktion zum Kühlen des wenigstens einen Schaltungsbauteils in Bezug auf die beiden Seiten der Leiterplatte voneinander entkoppelt, so dass, während die elektrische leitende Verbindung an einer Seite der Leiterplatte erfolgt, die Funktion zum Kühlen des wenigstens einen Schaltungsbauteils an der anderen Seite der Leiterplatte realisiert werden kann. Dies ermöglicht es, alle Schaltungsbauteile der elektrischen Schaltung auf der selben Seite der Leiterplatte elektrisch leitend mit dieser zu verbindenden und bei zumindest einem Teil der Schaltungsbauteile Maßnahmen zum Kühlen derselben an der anderen Seite der Leiterplatte bereitzustellen.

Bei der Maßnahme c) kann jeder Kontaktanschluss des wenigstens einen Schaltungsbauteils im Bereich einer an der ersten Seite der Leiterplatte vorgesehenen Leiterbahn positioniert werden, und bei der Maßnahme d) kann jeder Kontaktanschluss mit der jeweils zugeordneten Leiterbahn elektrisch leitend verbunden werden.

Um zum Kühlen des wenigstens einen Schaltungsbauteils beispielsweise durch Kontakt mit der Innenseite eines die elektrische Schaltung aufnehmenden Gehäuses einen ausreichenden Abstand der Kühlseite zur Leiterplatte bereitstellen zu können, wird vorgeschlagen, dass das wenigstens eine Schaltungsbauteil eine von der Kühlseite abgewandte Rückseite aufweist, dass, bezogen auf eine Rückseite-Kühlseite-Richtung, die Rückseite des wenigstens einen Schaltungsbauteils einen ersten Abstand zur ersten Seite der Leiterplatte aufweist und die Kühlseite einen zweiten Abstand zur zweiten Seite der Leiterplatte aufweist, und dass der erste Abstand kleiner ist als der zweite Abstand.

Zum Herstellen eines elektrisch leitenden Kontakts zwischen einem jeweiligen Kontaktanschluss und einer zugeordneten Leiterbahn kann bei der Maßnahme c) jeder im Bereich einer Leiterbahn an der ersten Seite der Leiterplatte zu positionierende Kontaktanschluss mit einer in einer Rückseite-Kühlseite-Richtung in Richtung zur Kühlseite orientierten Kontaktfläche an der jeweils zugeordneten Leiterbahn anliegend positioniert werden.

Um diese Anlagewechselwirkung bereitstellen zu können, kann bei der Maßnahme c) das wenigstens eine Schaltungsbauteil mit der Kühlseite vorangehend in Richtung auf die erste Seite der Leiterplatte zu und in die Aussparung hinein bewegt werden, bis jeder im Bereich einer Leiterbahn an der ersten Seite der Leiterplatte zu positionierende Kontaktanschluss mit seiner in Richtung zur Kühlseite orientierten Kontaktfläche an der jeweils zugeordneten Leiterbahn anliegend positioniert ist.

Für eine stabile elektrisch leitende Verbindung kann die Maßnahme c) das Anlöten jedes anliegend an einer Leiterbahn an der ersten Seite der Leiterplatte positionierten Kontaktanschlusses an die jeweils zugeordnete Leiterbahn umfassen.

Wenn bei der Maßnahme a) das wenigstens eine Schaltungsbauteil mit einem wenigstens einen Kontaktanschluss und eine Kühloberfläche an der Kühlseite des wenigstens einen Schaltungsbauteils bereitstellenden Kontaktelement bereitgestellt wird, ist dafür gesorgt, dass mit diesem im Allgemeinen mit Metallmaterial aufgebauten Kontaktelement auch eine gute Wärmeleitfähigkeit im Bereich der Kühloberfläche bereitgestellt wird.

Für eine effiziente Wärmeabfuhr kann die Kühloberfläche wenigstens 70% einer Gesamtoberfläche der Kühlseite des wenigstens einen Schaltungsbauteils einnehmen.

Um eine definierte Positionierung des wenigstens einen Schaltungsbauteils zur thermischen Wechselwirkung mit wärmeabführenden Komponenten erreichen zu können, wird vorgeschlagen, dass bei der Maßnahme c) das wenigstens eine Schaltungsbauteil derart in die Aussparung eingesetzt wird, dass die Kühlseite im Wesentlichen parallel zur zweiten Seite der Leiterplatte positioniert ist.

Um eine hohe Variabilität im Aufbau einer elektrischen Schaltung erreichen zu können, wird vorgeschlagen, dass das Verfahren ferner die Maßnahmen umfasst:
e) Bereitstellen wenigstens eines weiteren Schaltungsbauteils mit einer Mehrzahl von Kontaktanschlüssen und einer Kühlseite,
f) Anordnen des wenigstens einen weiteren Schaltungsbauteils an der ersten Seite der Leiterplatte derart, dass wenigstens ein Teil der Kontaktanschlüsse des wenigstens einen weiteren Bauteils an der ersten Seite der Leiterplatte im Bereich von an der ersten Seite der Leiterplatte vorgesehenen Leiterbahnen positioniert wird und die Kühlseite des wenigstens einen Schaltungsbauteils an der ersten Seite der Leiterplatte und im Wesentlichen in Richtung von der ersten Seite der Leiterplatte weg orientiert positioniert wird,
g) elektrisch leitendes Verbinden jedes im Bereich einer Leiterbahn an der ersten Seite der Leiterplatte positionierten Kontaktanschlusses mit der jeweils zugeordneten Leiterbahn.

Gemäß einem weiteren Aspekt wird die eingangs angeführte Aufgabe gelöst durch eine elektrische Schaltung, umfassend eine Leiterplatte und wenigstens ein Schaltungsbauteil mit einer Mehrzahl von Kontaktanschlüssen, wobei die Leiterplatte in Zuordnung zu dem wenigstens einen Schaltungsbauteil eine Aussparung und Leiterbahnen wenigstens an einer ersten Seite der Leiterplatte aufweist, wobei das wenigstens eine Schaltungsbauteil in die zugeordnete Aussparung derart eingesetzt ist, dass wenigstens ein Teil der Kontaktanschlüsse des wenigstens einen Bauteils an der ersten Seite der Leiterplatte im Bereich von an der ersten Seite der Leiterplatte vorgesehenen Leiterbahnen positioniert und damit elektrisch leitend verbunden ist, und wobei eine Kühlseite des wenigstens einen Schaltungsbauteils an einer von der ersten Seite abgewandten zweiten Seite der Leiterplatte und im Wesentlichen in Richtung von der zweiten Seite der Leiterplatte weg orientiert positioniert ist.

Für eine effiziente Wärmeabfuhr aus dem wenigstens einen Schaltungsbauteil wird vorgeschlagen, dass das wenigstens eine Schaltungsbauteil ein wenigstens einen Kontaktanschluss und eine Kühloberfläche an der Kühlseite des wenigstens einen Schaltungsbauteils bereitstellendes Kontaktelement umfasst.

Bei der erfindungsgemäß aufgebauten elektrischen Schaltung kann jeder im Bereich einer Leiterbahn an der ersten Seite der Leiterplatte positionierte Kontaktanschluss mit einer in einer Rückseite-Kühlseite-Richtung in Richtung zur Kühlseite orientierten Kontaktfläche an der jeweils zugeordneten Leiterbahn anliegend positioniert sein.

An der Leiterplatte kann wenigstens ein weiteres, eine Mehrzahl von Kontaktanschlüssen und eine Kühlseite aufweisendes Schaltungsbauteil derart angeordnet sein, dass wenigstens ein Teil der Kontaktanschlüsse des wenigstens einen weiteren Schaltungsbauteils mit Leiterbahnen an der ersten Seite der Leiterplatte elektrisch leitend verbunden ist und die Kühlseite des wenigstens einen weiteren Schaltungsbauteils an der ersten Seite der Leiterplatte und im Wesentlichen in Richtung von der ersten Seite der Leiterplatte weg orientiert positioniert ist.

Die vorliegende Erfindung wird nachfolgend mit Bezug auf die beiliegenden Figuren detailliert beschrieben. Es zeigt:
- Fig. 1: eine perspektivische Ansicht einer elektrischen Schaltung mit zwei an einer Leiterplatte vorgesehenen Schaltungsbauteilen;
- Fig. 2: eine prinzipartige Schnittansicht durch ein an einer Leiterplatte vorgesehenes Schaltungsbauteil.

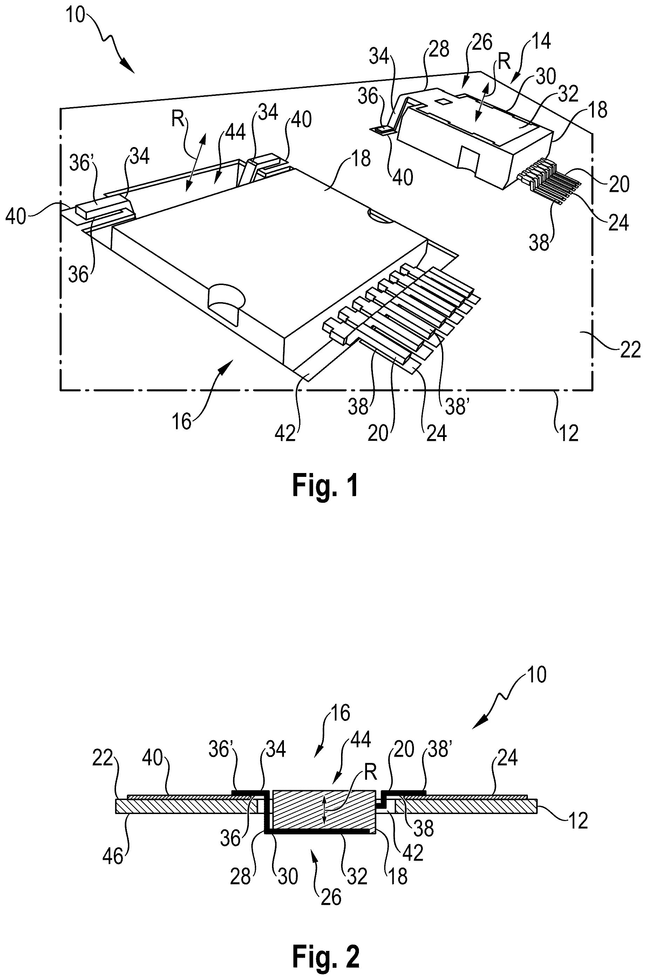

In Fig. 1 ist eine allgemein mit 10 bezeichnete elektrische Schaltung dargestellt. Die elektrische Schaltung 10 umfasst eine abschnittsweise dargestellte Leiterplatte 12 mit zwei daran vorgesehenen, im dargestellten Ausgestaltungsbeispiel zueinander im Wesentlichen gleich ausgestalteten Schaltungsbauteilen 14, 16. Jedes der beiden Schaltungsbauteile 14, 16 umfasst ein beispielsweise mit Kunststoffmaterial aufgebautes Gehäuse 18, aus welchem eine Gruppe von Kontaktanschlüssen 20 hervorstehend ausgebildet ist. In Zuordnung zu jedem der Kontaktanschlüsse 20 ist an einer in Fig. 1 erkennbaren bzw. nach oben orientierten ersten Seite 22 der Leiterplatte 12 eine jeweilige Leiterbahn 24 vorgesehen.

An dem Gehäuse 18 ist an einer bei dem Schaltungsbauteil 14 in Fig. 2 nach oben orientierten und damit sichtbaren und bei dem Schaltungsbauteil 16 in Fig. 1 nach unten orientierten und damit nicht sichtbaren Kühlseite 26 ein Kontaktelement 28 festgelegt, welches mit einem plattenartigen Körper 30 im Wesentlichen die gesamte Kühlseite 26 bereitstellt bzw. bedeckt. Beispielsweise kann der Körper 30 derart dimensioniert sein, dass eine daran ausgebildete Kühloberfläche 32 wenigstens 70% der Gesamtoberfläche des Gehäuses 18 an der Kühlseite 26 einnimmt.

Von dem Körper 30 erstrecken sich zwei weitere Kontaktanschlüsse 34. Zur Überbrückung der Dicke des Gehäuses 18 erstrecken die Kontaktanschlüsse 34 sich im Wesentlichen in einer Rückseite-Kühlseite-Richtung R, so dass daran gebildete Kontaktflächen 36 in einer zur Rückseite-Kühlseite-Richtung R im Wesentlichen orthogonalen, gemeinsamen Ebene mit an den Kontaktanschlüssen 20 gebildeten Kontaktflächen 38 liegen.

Es ist in diesem Zusammenhang darauf hinzuweisen, dass die Kontaktanschlüsse 20, 34 an beiden in der Rückseite-Kühlseite-Richtung R einander entgegengesetzten Seiten jeweils derartige Kontaktflächen 36 bzw. 36' und 38 bzw. 38' aufweisen, so dass je nach Einbausituation die Kontaktflächen 36, 38 an den zugeordneten Leiterbahnen 24, 40 an der ersten Seite 22 der Leiterplatte 12 anliegen, oder die Kontaktflächen 36', 38' an den zugeordneten Leiterbahnen 24, 40 anliegen.

Zur Herstellung einer festen und elektrisch leitenden Verbindung sind die Kontaktanschlüsse 20, 34 mit den zugeordneten Leiterbahnen 24, 40 beispielsweise durch Verlöten verbunden.

Bei der in Fig. 1 dargestellten elektrischen Schaltung 10 ist das Schaltungsbauteil 14 vollständig an der ersten Seite der Leiterplatte 22 angeordnet, so dass, wie vorangehend dargelegt, die Kontaktflächen 36', 38' der Kontaktanschlüsse 20, 34 in elektrisch leitender Verbindung mit den zugeordneten Leiterbahnen 24, 40 an der ersten Seite 22 der Leiterplatte 12 sind und die Kühlseite 26 an der ersten Seite 22 der Leiterplatte 12 positioniert und von dieser weg orientiert ist.

Das Schaltungsbauteil 16 der elektrischen Schaltung 10 ist in zur Einbausituation des Schaltungsbauteils 14 umgedrehter Positionierung an die Leiterplatte 12 angebunden. Zu diesem Zweck ist in der Leiterplatte 12 in Zuordnung zum Schaltungsbauteil 16 eine Aussparung 42 vorgesehen, in welche beim Aufbau der elektrischen Schaltung 10 das Schaltungsbauteil 16 mit seiner in Fig. 1 nicht erkennbaren Kühlseite 26 vorangehend eingesetzt wird, so dass in der Ansicht der Fig. 1 die von der Kühlseite 26 abgewandt orientierte Rückseite 44 des Gehäuses 18 bzw. des Schaltungsbauteils 16 erkennbar ist bzw. in der gleichen Richtung orientiert ist, wie die erste Seite 22 der Leiterplatte 12.

Das Schaltungsbauteil 16 wird in die Aussparung 42 so weit eingeführt, dass die Kontaktanschlüsse 20, 34 mit ihren in der Rückseite-Kühlseite-Richtung R zur Kühlseite 26 orientierten Kontaktflächen 36, 38 in Anlage an den zugeordneten Leiterbahnen 24, 40 sind. Da alle Kontaktelemente 20, 34 mit den daran vorgesehenen Kontaktflächen 36, 36', 38, 38' näher an der Rückseite 44 als an der Kühlseite 26 positioniert sind, ergibt sich somit eine in Fig. 3 auch erkennbare Einbausituation, bei welcher ein Abstand der Rückseite 44 zur ersten Seite 22 der Leiterplatte 12 in der Rückseite-Kühlseite-Richtung R kleiner ist, als ein Abstand der Kühlseite 26 zu einer zur ersten Seite 22 im Wesentlichen entgegengesetzt orientierten zweiten Seite 46 der Leiterplatte 12 in der Rückseite-Kühlseite-Richtung R. Dabei kann, wie in Fig. 3 veranschaulicht, die Rückseite 44 des Gehäuses 12 bzw. des Schaltungsbauteils 16 noch über die erste Seite 22 der Leiterplatte 12 hervorstehend positioniert sein oder kann alternativ auch bündig dazu liegen oder in der Aussparung 42 aufgenommen sein.

Bei der in den Fig. 1 und 3 in Verbindung mit dem Schaltungsbauteil 16 dargestellten Einbausituation erfolgt die elektrisch leitende Verbindung der Kontaktelemente 20, 34 mit den zugeordneten Leiterbahnen 24, 40 einer der ersten Seite 22 der Leiterplatte 12, während die Kühlseite 26 des Schaltungsbauteils 16 an der zweiten Seite 46 der Leiterplatte 12 positioniert und von dieser abgewandt orientiert ist. Dies ermöglicht es, das Schaltungsbauteil 16 mit seiner Kühlseite 26, insbesondere dem Körper 30 des Kontaktelements 28, beispielsweise in Wärmeübertragungskontakt mit der Innenseite eines die elektrische Schaltung 10 aufnehmenden Gehäuses zu bringen, um Wärme aus dem Schaltungsbauteil 16 abzuführen. Somit wird es möglich, eine Kühlwechselwirkung auch an derjenigen Seite der Leiterplatte 12 bereitzustellen, an welcher nicht notwendigerweise auch Leiterbahnen vorhanden sind. Dies bedeutet, dass alle an der Leiterplatte 12 vorgesehenen bzw. vorzusehenden Schaltungsbauteile mit an der selben Seite, im dargestellten Beispiel der ersten Seite 22, der Leiterplatte 12 vorgesehenen Leiterbahnen insbesondere durch Verlöten elektrisch leitend fest verbunden werden können, während bei zumindest einem Teil dieser Schaltungsbauteile die Kühlfunktion an der andere Seite, im dargestellten Beispiel also der zweiten Seite 46, der Leiterplatte 12 realisiert ist. Dies gestattet es, alle an der Leiterplatte 12 vorzusehenden Schaltungsbauteile an derselben Seite mit dort vorgesehenen Leiterbahnen elektrisch leitend zu verbinden, so dass eine Lötprozedur auch nur an einer Seite der Leiterplatte 12 durchzuführen ist. Dies führt zu einem im Vergleich zu einer an beiden Seiten durchzuführenden Lötprozedur deutlich einfacheren Herstellungsprozess, gestattet gleichzeitig aber auch die Verlagerung der Kühlfunktion auf die andere Seite der Leiterplatte bzw. die Aufteilung der Kühlfunktion auf beide Seiten der Leiterplatte, wie dies in Fig. 1 anhand der beiden dort vorgesehenen Schaltungsbauteile 14, 16 realisiert ist.

Es ist abschließend darauf hinzuweisen, dass selbstverständlich die an der Leiterplatte 12 vorzusehenden Schaltungsbauteile grundsätzlich anders strukturiert und dimensioniert sein können, als dies im Zusammenhang mit den zueinander im Wesentlichen identisch aufgebauten Schaltungsbauteilen 14, 16 dargestellt ist. Insbesondere können sich die Form der jeweiligen Gehäuse und die Anzahlen der an jeweilige Leiterbahnen elektrisch leitend anzubindenden Kontaktanschlüsse unterscheiden. Auch ist darauf hinzuweisen, dass, obgleich bei den in Fig. 1 dargestellten Schaltungsbauteilen 14, 16 die Kühlseite 26 und die Rückseite 44 zueinander im Wesentlichen parallel orientiert sind und bei an der Leiterplatte 12 angebrachten Schaltungsbauteilen 14, 16 zur ersten Seite 22 bzw. zur zweiten Seite 46 der Leiterplatte 12 im Wesentlichen parallel orientiert sind, was insbesondere im Kontext der Kühlseite 26 zur Erzeugung einer Kühlwechselwirkung beispielsweise mit einem Gehäuse vorteilhaft ist, auch andere Geometrien, beispielsweise kugelartige oder zylinderartige Strukturen derartiger Schaltungsbauteile vorgesehen sein können.

Weiter ist darauf hinzuweisen, dass bei einer derartigen elektrischen Schaltung beispielsweise auch alle an der Leiterplatte 12 vorgesehenen Schaltungsbauteile in der in Zuordnung zum Schaltungsbauteil 16 dargestellten Orientierung an der Leiterplatte 12 vorgesehen sein können, oder dass beispielsweise alle Schaltungsbauteile, für welche eine Kühlfunktion bzw. eine Kühlwechselwirkung mit einer kühlenden Komponente vorgesehen sein soll, in dieser Orientierung in eine jeweils zugeordnete Aussparung in der Leiterplatte 12 eingesetzt und entsprechend an die zugeordneten Leiterbahnen elektrisch leitend angebunden sein können.

Die mit Bezug auf das Schaltungsbauteil 16 dargestellte Integration eines Schaltungsbauteils in eine elektrische Schaltung kann grundsätzlich auch Anwendung finden bei elektrischen Schaltungen, deren Leiterplatten auf beiden Seiten Leiterbahnen aufweisen und bei welchen dementsprechend an beiden Seiten Schaltungsbauteile elektrisch leitend mit dort jeweils vorgesehenen Leiterbahnen zu verbinden sind. Bei derart aufgebauten elektrischen Schaltungen könnte beispielsweise vorgesehen sein, dass alle eine Kühlung erfordernden Schaltungsbauteile derart an der Leiterplatte angebracht sind, dass deren Kühlseiten an der gleichen Seite der Leiterplatte positioniert sind.

## Patentansprüche

1. Verfahren zum Aufbau einer elektrischen Schaltung (10), die elektrische Schaltung (10) umfassend eine Leiterplatte (12) und wenigstens ein Schaltungsbauteil (16) mit einer Mehrzahl von Kontaktanschlüssen (20, 34), wobei wenigstens ein Teil der Kontaktanschlüsse (20, 34) mit an der selben Seite der Leiterplatte (12) vorgesehenen Leiterbahnen (24, 40) der Leiterplatte (12) elektrisch leitend verbunden ist, und wobei das wenigstens eine Schaltungsbauteil (16) eine an einer Seite der Leiterplatte (12) positionierte und in Richtung von der Leiterplatte (12) weg orientierte Kühlseite (26) aufweist, wobei das Verfahren die Maßnahmen umfasst:
a) Bereitstellen wenigstens eines Schaltungsbauteils (16) mit einer Mehrzahl von Kontaktanschlüssen (20, 34) und einer Kühlseite (26),
b) Bereitstellen einer Leiterplatte (12) mit einer in Zuordnung zu dem wenigstens einen Schaltungsbauteil (16) vorgesehenen Aussparung (42) und Leiterbahnen (24, 40) wenigstens an einer ersten Seite (22) der Leiterplatte (12),
c) Einsetzen des wenigstens einen Schaltungsbauteils (16) in die Aussparung (42) derart, dass wenigstens ein Teil der Kontaktanschlüsse (20, 34) des wenigstens einen Schaltungsbauteils (16) an der ersten Seite (22) der Leiterplatte (12) im Bereich von an der ersten Seite (22) der Leiterplatte (12) vorgesehenen Leiterbahnen (24, 40) positioniert wird und die Kühlseite (26) des wenigstens einen Schaltungsbauteils (16) an einer von der ersten Seite (22) abgewandten zweiten Seite (46) der Leiterplatte (12) und im Wesentlichen in Richtung von der zweiten Seite (46) der Leiterplatte (12) weg orientiert positioniert wird,
d) elektrisch leitendes Verbinden jedes im Bereich einer Leiterbahn (24, 40) an der ersten Seite (22) der Leiterplatte (12) positionierten Kontaktanschlusses (20, 34) mit der jeweils zugeordneten Leiterbahn (24, 40).

2. Verfahren nach Anspruch 1,
**dadurch gekennzeichnet, dass** bei der Maßnahme c) jeder Kontaktanschluss (20, 34) des wenigstens einen Schaltungsbauteils (16) im Bereich einer an der ersten Seite (22) der Leiterplatte (12) vorgesehenen Leiterbahn (24, 40) positioniert wird und bei der Maßnahme d) jeder Kontaktanschluss (20, 34) mit der jeweils zugeordneten Leiterbahn (24, 40) elektrisch leitend verbunden wird.

3. Verfahren nach Anspruch 1 oder 2,
**dadurch gekennzeichnet, dass** das wenigstens eine Schaltungsbauteil (16) eine von der Kühlseite (26) abgewandte Rückseite (44) aufweist, dass, bezogen auf eine Rückseite-Kühlseite-Richtung (R), die Rückseite (44) des wenigstens einen Schaltungsbauteils (16) einen ersten Abstand zur ersten Seite (22) der Leiterplatte (12) aufweist und die Kühlseite (26) einen zweiten Abstand zur zweiten Seite (46) der Leiterplatte (12) aufweist, und dass der erste Abstand kleiner ist als der zweite Abstand.

4. Verfahren nach einem der Ansprüche 1-3,
**dadurch gekennzeichnet, dass** bei der Maßnahme c) jeder im Bereich einer Leiterbahn (24, 40) an der ersten Seite (22) der Leiterplatte (12) zu positionierende Kontaktanschluss (20, 34) mit einer in einer Rückseite-Kühlseite-Richtung (R) in Richtung zur Kühlseite (26) orientierten Kontaktfläche (36, 38) an der jeweils zugeordneten Leiterbahn (24, 40) anliegend positioniert wird.

5. Verfahren nach Anspruch 4,
**dadurch gekennzeichnet, dass** bei der Maßnahme c) das wenigstens eine Schaltungsbauteil (16) mit der Kühlseite (26) vorangehend in Richtung auf die erste Seite (22) der Leiterplatte (12) zu und in die Aussparung (42) hinein bewegt wird, bis jeder im Bereich einer Leiterbahn (24, 40) an der ersten Seite (22) der Leiterplatte (12) zu positionierende Kontaktanschluss (20, 34) mit seiner in Richtung zur Kühlseite (26) orientierten Kontaktfläche (36, 38) an der jeweils zugeordneten Leiterbahn (24, 40) anliegend positioniert ist.

6. Verfahren nach einem der Ansprüche 1-5,
**dadurch gekennzeichnet, dass** die Maßnahme c) das Anlöten jedes anliegend an einer Leiterbahn (24, 40) an der ersten Seite (22) der Leiterplatte (12) positionierten Kontaktanschlusses (20, 34) an die jeweils zugeordnete Leiterbahn (24, 40) umfasst.

7. Verfahren nach einem der Ansprüche 1-6,
**dadurch gekennzeichnet, dass** bei der Maßnahme a) das wenigstens eine Schaltungsbauteil (16) mit einem wenigstens einen Kontaktanschluss (34) und eine Kühloberfläche (32) an der Kühlseite (26) des wenigstens einen Schaltungsbauteils (16) bereitstellenden Kontaktelement (28) bereitgestellt wird.

8. Verfahren nach Anspruch 7,
**dadurch gekennzeichnet, dass** die Kühloberfläche (32) wenigstens 70% einer Gesamtoberfläche der Kühlseite (26) des wenigstens einen Schaltungsbauteils (16) einnimmt.

9. Verfahren nach einem der Ansprüche 1-8,
**dadurch gekennzeichnet, dass** bei der Maßnahme c) das wenigstens eine Schaltungsbauteil (16) derart in die Aussparung (42) eingesetzt wird, dass die Kühlseite (26) im Wesentlichen parallel zur zweiten Seite (46) der Leiterplatte (12) positioniert ist.

10. Verfahren nach einem der Ansprüche 1-9,
**dadurch gekennzeichnet, dass** das Verfahren ferner die Maßnahmen umfasst:
e) Bereitstellen wenigstens eines weiteren Schaltungsbauteils (14) mit einer Mehrzahl von Kontaktanschlüssen (20, 34) und einer Kühlseite (26),
f) Anordnen des wenigstens einen weiteren Schaltungsbauteils (14) an der ersten Seite (22) der Leiterplatte (12) derart, dass wenigstens ein Teil der Kontaktanschlüsse (20, 34) des wenigstens einen weiteren Bauteils (14) an der ersten Seite (22) der Leiterplatte (12) im Bereich von an der ersten Seite (22) der Leiterplatte (12) vorgesehenen Leiterbahnen (24, 40) positioniert wird und die Kühlseite (26) des wenigstens einen Schaltungsbauteils (14) an der ersten Seite (22) der Leiterplatte (12) und im Wesentlichen in Richtung von der ersten Seite (22) der Leiterplatte (12) weg orientiert positioniert wird,
g) elektrisch leitendes Verbinden jedes im Bereich einer Leiterbahn (24,40) an der ersten Seite (22) der Leiterplatte (12) positionierten Kontaktanschlusses (20, 34) mit der jeweils zugeordneten Leiterbahn (24, 40).

11. Elektrische Schaltung (10), umfassend eine Leiterplatte (22) und wenigstens ein Schaltungsbauteil (16) mit einer Mehrzahl von Kontaktanschlüssen (20, 34), wobei die Leiterplatte (12) in Zuordnung zu dem wenigstens einen Schaltungsbauteil (16) eine Aussparung (42) und Leiterbahnen (24, 40) wenigstens an einer ersten Seite (22) der Leiterplatte (12) aufweist, wobei das wenigstens eine Schaltungsbauteil (14) in die zugeordnete Aussparung (42) derart eingesetzt ist, dass wenigstens ein Teil der Kontaktanschlüsse (20, 34) des wenigstens einen Bauteils (16) an der ersten Seite (22) der Leiterplatte (12) im Bereich von an der ersten Seite (22) der Leiterplatte (12) vorgesehenen Leiterbahnen (24, 40) positioniert und damit elektrisch leitend verbunden ist, und wobei eine Kühlseite (26) des wenigstens einen Schaltungsbauteils (16) an einer von der ersten Seite (22) abgewandten zweiten Seite (46) der Leiterplatte (12) und im Wesentlichen in Richtung von der zweiten Seite (46) der Leiterplatte (12) weg orientiert positioniert ist.

12. Elektrische Schaltung nach Anspruch 11,
**dadurch gekennzeichnet, dass** das wenigstens eine Schaltungsbauteil (16) ein wenigstens einen Kontaktanschluss (34) und eine Kühloberfläche (32) an der Kühlseite (26) des wenigstens einen Schaltungsbauteils (16) bereitstellendes Kontaktelement (28) umfasst.

13. Elektrische Schaltung nach Anspruch 11 oder 12,
**dadurch gekennzeichnet, dass** jeder im Bereich einer Leiterbahn (24, 40) an der ersten Seite (22) der Leiterplatte (12) positionierte Kontaktanschluss (20, 34) mit einer in einer Rückseite-Kühlseite-Richtung (R) in Richtung zur Kühlseite (26) orientierten Kontaktfläche (36, 38) an der jeweils zugeordneten Leiterbahn (24, 40) anliegend positioniert ist.

14. Elektrische Schaltung nach einem der Ansprüche 11-13,
**dadurch gekennzeichnet, dass** an der Leiterplatte (12) wenigstens ein weiteres, eine Mehrzahl von Kontaktanschlüssen (20, 34) und eine Kühlseite (26) aufweisendes Schaltungsbauteil (14) derart angeordnet ist, dass wenigstens ein Teil der Kontaktanschlüsse (20, 34) des wenigstens einen weiteren Schaltungsbauteils (14) mit Leiterbahnen (24, 40) an der ersten Seite (22) der Leiterplatte (12) elektrisch leitend verbunden ist und die Kühlseite (26) des wenigstens einen weiteren Schaltungsbauteils (14) an der ersten Seite (22) der Leiterplatte (12) und im Wesentlichen in Richtung von der ersten Seite (22) der Leiterplatte (12) weg orientiert positioniert ist.
